(19) Europäisches Patentamt
European Patent Office
Office européen des brevets

(11) **EP 3 255 453 B1**

(12) **EUROPEAN PATENT SPECIFICATION**

(45) Date of publication and mention
of the grant of the patent:
**24.10.2018 Bulletin 2018/43**

(51) Int Cl.:
*G01S 13/56* (2006.01)          *H03L 7/091* (2006.01)
*H03L 7/087* (2006.01)          *H03L 7/093* (2006.01)
*H03L 7/24* (2006.01)

(21) Application number: **17174502.9**

(22) Date of filing: **06.06.2017**

(54) **SUBSAMPLING MOTION DETECTOR FOR DETECTING MOTION OF OBJECT UNDER MEASUREMENT**

UNTERABTASTUNG EINES BEWEGUNGSDETEKTORS ZUR DETEKTION DER BEWEGUNG EINES OBJEKTS WÄHREND DER MESSUNG

DÉTECTEUR DE MOUVEMENT DE SOUS-ÉCHANTILLONNAGE POUR DÉTECTER LE MOUVEMENT D'UN OBJET À MESURER

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.06.2016 US 201615173723**

(43) Date of publication of application:
**13.12.2017 Bulletin 2017/50**

(73) Proprietor: **RichWave Technology Corp.
Taipei City 114 (TW)**

(72) Inventor: **Chen, Tse-Peng
Taipei City 114 (TW)**

(74) Representative: **Becker Kurig Straus
Patentanwälte
Bavariastrasse 7
80336 München (DE)**

(56) References cited:
**US-A1- 2010 237 953      US-A1- 2012 235 689
US-A1- 2014 036 970      US-B1- 7 737 743**

**Description**

Field of the Invention

The invention relates to a motion detector, and more particularly, to a subsampling motion detector for detecting motion of an object under measurement.

Background of the Invention

In general, a motion detector detecting the status of displacement of an object by the Doppler Effect requires a high frequency signal output from an oscillation source operated at a high frequency to update the status of displacement of the object. Many of these motion detectors use a phase lock loop (PLL) to stabilize the high frequency oscillation signal. However, a PLL typically requires one of two implementations. In one method, a frequency divider is used for dividing the high frequency oscillation signal before the divided signal is then compared with a low frequency reference signal by a phase detector. U.S. Patent Application 2012/0235689 and U.S. Patent 7,737,743 are examples of phase-locked loop (PLL) circuitry, which use a frequency divider.

Unfortunately, the frequency divider could consume a great deal of power during operation of the PLL. In an alternate method, a high frequency reference signal is provided for comparison with the high frequency oscillation signal by a phase detector. In this case, although the high frequency oscillation signal is not divided by a frequency divider, the phase detector has to perform phase detection at a fast rate, which could lead to increased power consumption.

Therefore, a solution with lower power consumption is required in this field.

Summary of the Invention

According to an exemplary embodiment of the claimed invention, a subsampling motion detector configured to detect motion information of an object under measurement is disclosed. The subsampling motion detector receives a first wireless radio frequency (RF) signal and transmits a second wireless RF signal, the first wireless RF signal being generated by reflecting the second wireless RF signal from the object. The subsampling motion detector includes a high frequency oscillator outputting a high frequency oscillation signal, wherein the first wireless RF signal is injected to the high frequency oscillator for controlling the high frequency oscillator through injecting locking, a low frequency controllable oscillator generating a low frequency oscillation signal according to a control signal, and a subsampling phase detector (SSPD) receiving the high frequency oscillation signal and the low frequency oscillation signal and detecting a phase difference between the high frequency oscillation signal and the low frequency oscillation signal at time periods indicated by the low frequency oscillation signal, the SSPD outputting a phase detection output signal according to the detected phase difference, the control signal being generated according to the phase detection output signal output from the SSPD, and the motion information of the object being calculated according to the phase detection output signal.

According to yet another exemplary embodiment of the claimed invention, a subsampling motion detector configured to detect motion information of an object under measurement is disclosed. The subsampling motion detector receives a first wireless radio frequency (RF) signal and transmits a second wireless RF signal, the first wireless RF signal being generated by reflecting the second wireless RF signal from the object. The subsampling motion detector includes a high frequency oscillator outputting a high frequency oscillation signal, wherein the first wireless RF signal is injected to the high frequency oscillator for controlling the high frequency oscillator through injecting locking, a low frequency controllable oscillator generating a low frequency oscillation signal according to a control signal, and a subsampling analog-to-digital converter (SSADC) receiving the high frequency oscillation signal and the low frequency oscillation signal and detecting a phase difference between the high frequency oscillation signal and the low frequency oscillation signal at time periods indicated by the low frequency oscillation signal, the SSADC outputting a phase detection digital output signal according to the detected phase difference, the control signal being generated according to the phase detection digital output signal output from the SSADC, and the motion information of the object being calculated according to the phase detection digital output signal.

Brief Description of the Drawings

Fig. 1 is illustrates a motion detector according to an example.
Fig. 2 illustrates relative frequencies of the carrier frequency fc and the reference frequency fXTAL.
Fig. 3 illustrates a motion detector according to a second example.
Fig. 4 illustrates a motion detector depicting a generalized version of the first example and the second example.
Fig. 5 illustrates a motion detector according to a first embodiment of the present invention.
Fig. 6 illustrates relative frequencies of the carrier frequency fc and the low frequency oscillation signal fs.
Fig. 7 illustrates a motion detector according to a second embodiment of the present invention.
Fig. 8 illustrates a motion detector depicting a generalized version of the first embodiment and the second embodiment of the present invention.
Fig. 9 illustrates a motion detector according to a third embodiment of the present invention.

Fig. 10 illustrates a motion detector according to a fourth embodiment of the present invention.

Fig. 11 illustrates a motion detector depicting a generalized version of the third embodiment and the fourth embodiment of the present invention.

Fig. 12 illustrates a motion detector according to another embodiment of the present invention.

FIG. 13 illustrates the frequency multiplier in FIG. 12 according to an embodiment of the present invention.

FIG. 14 illustrates that the frequency multiplier of FIG. 13 is coupled to the oscillation source and transceiver according to an embodiment of the present invention.

FIG. 15 illustrates the frequency multiplier in FIG. 12 according to another embodiment of the present invention.

FIG. 16 illustrates another detector according to another embodiment of the present invention.

Detailed Description

Below, exemplary embodiments will be described in detail with reference to accompanying drawings so as to be easily realized by a person having ordinary knowledge in the art. The inventive concept may be embodied in various forms without being limited to the exemplary embodiments set forth herein. Descriptions of well-known parts are omitted for clarity, and like reference numerals refer to like elements throughout.

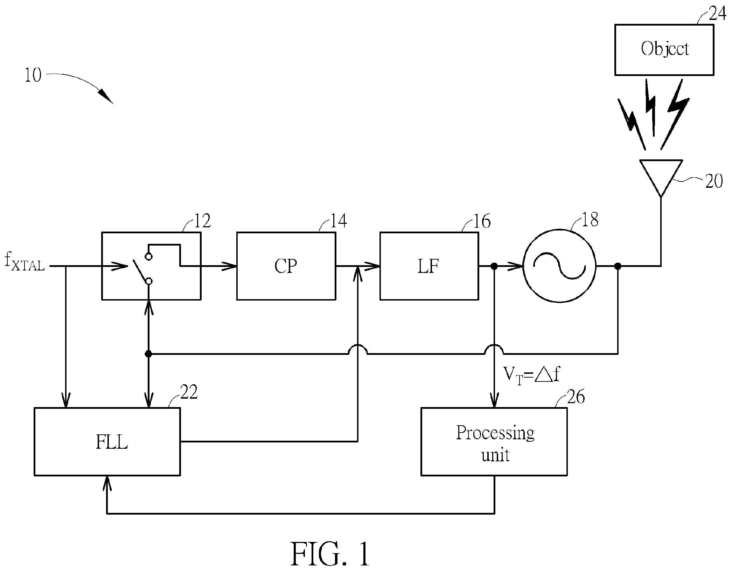

Please refer to Fig. 1. Fig. 1 illustrates a motion detector 10 according to a first example. The motion detector 10 is created using primarily analog components, and comprises a transceiver 20 that may optionally include one or more antennas, a subsampling phase detector (SSPD) 12, a charge pump 14, a loop filter 16, a voltage-controlled oscillator (VCO) 18, and a frequency lock loop (FLL) 22. The transceiver 20 receives a first wireless radio frequency (RF) signal and thereby generates a corresponding first electrical signal. The transceiver 20 is coupled to an output end of the VCO 18 through a transceiving node (not shown) and generates a second wireless RF signal that is output from the transceiver 20 to an object 24 under measurement. When the second wireless RF signal contacts the object 24, the object 24 reflects the first wireless RF signal back to the transceiver 20. Due to the Doppler Effect, the frequency of the first wireless RF signal is different from that of the second wireless RF signal. When the transceiver 20 converts the received first wireless RF signal into the corresponding first electrical signal, the first electrical signal is then input into an injection end of the VCO 18. Due to the phenomena of injection pulling and injection locking, an oscillation frequency of the VCO 18 varies due to influence of both environmental effects and a Doppler shift caused by the object 24. In other words, the oscillation frequency of the VCO 18 varies along with variation of the first electrical signal produced by the transceiver 20.

A crystal oscillator or other such reference generator provides a reference frequency fXTAL, which is input into the SSPD 12. Besides receiving an input of the reference frequency fXTAL, the SSPD 12 also has an input for receiving the oscillation signal from the VCO 18. The SSPD 12 performs phase detection by comparing phase differences of the reference frequency fXTAL and the oscillation signal from the VCO 18. The SSPD 12 samples the oscillation signal at a frequency controlled by the reference frequency fXTAL for performing the phase detection function. The motion detector 10 is designed such that a frequency of the oscillation signal output from the VCO 18 is an integer multiple or fractional multiple (such as 1.5) of the frequency of the reference frequency fXTAL, wherein the value of the multiple or a fractional multiplication factor is greater than 1. Therefore, the SSPD 12 in effect provides the function of dividing the frequency of the oscillation signal into a lower frequency signal. The SSPD 12 uses much less power than a traditional phase detector and frequency divider combination of a phase lock loop (PLL).

When the SSPD 12 detects the phase difference between the oscillation signal and the reference frequency fXTAL at time periods indicated by the reference frequency fXTAL, the SSPD 12 outputs a phase detection output signal to the charge pump 14 according to the detected phase difference. The charge pump 14 converts the phase detection output signal received from the SSPD 12 into an output current signal, and the loop filter 16 converts the output current signal into the control voltage used to control the VCO 18. The oscillation signal of the VCO 18 is locked to a multiple or fractional multiple of the reference frequency fXTAL. The control voltage used to control the VCO 18 can be used to extract the motion information of the object 24. When the object 24 is not moving, and there is no environmental interference, the oscillation frequency of the VCO 18 is a carrier frequency fc. However, due to injection pulling, the oscillation frequency of the VCO 18 can be pulled to fc + $\Delta$f, where $\Delta$f is a frequency difference that is equal to a sum of a Doppler shift fd caused by the object 24 and an injection pulling frequency shift fb caused by environmental interference. The control voltage used to control the VCO 18 can be represented as a tuning voltage VT, which can represent the frequency difference $\Delta$f. Therefore, by providing the tuning voltage VT to a processing unit 26, it is possible to extract the Doppler shift fd caused by the object 24 while ignoring the effects of the injection pulling frequency shift fb. In order to prevent aliasing effect, the reference frequency fXTAL should be greater than or equal to twice the frequency difference $\Delta$f. Also, in order to isolate the Doppler shift fd from the injection pulling frequency shift fb, a bandwidth of the loop filter 16, which may be implemented as a low-pass filter, should be small enough.

The FLL 22 receives as inputs both the reference frequency fXTAL and the oscillation signal of the VCO 18. The FLL 22 can be controllably turned on and off, and the FLL 22 assists the SSPD 12 with detecting a phase difference between the oscillation signal and the reference frequency fXTAL when the FLL 22 is turned on. The FLL 22 can modify the output current signal that is provided from the charge pump 14 into the loop filter 16 for helping to control the function of the loop filter 16 when the SSPD 12 is unable to easily detect the phase difference between the oscillation signal and the reference frequency fXTAL. By keeping the FLL 22 turned off when it is not needed, and by not using a frequency divider, the motion detector 10 is able to save significant amounts of power during normal operation. The processing unit 26 can determine when it is necessary to turn on and off the FLL 22, the processing unit 26 outputs a control signal to the FLL 22 for controlling when to turn on and turn off the FLL 22. A timer in the processing unit 26 can be used to periodically turn on the FLL 22 for several cycles to ensure that the SSPD 12 is properly detecting the phase difference between the oscillation signal and the reference frequency fXTAL.

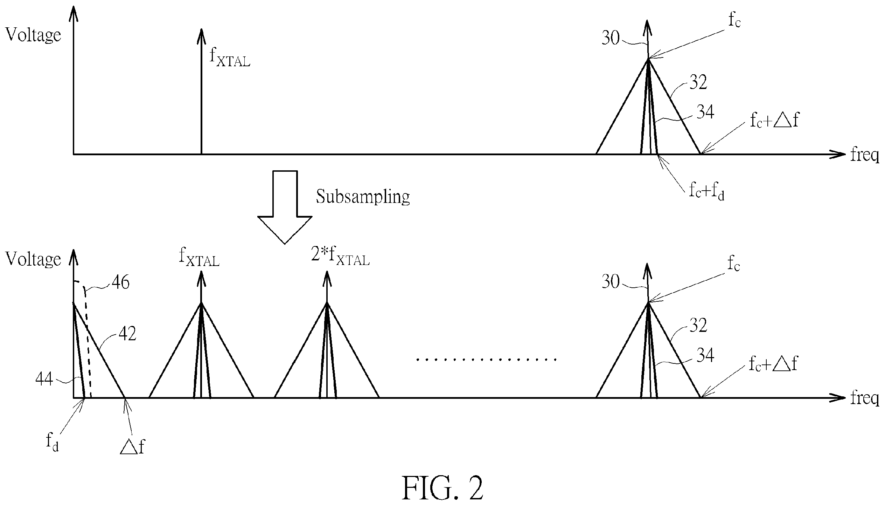

Please refer to Fig. 2. Fig. 2 illustrates relative frequencies of the carrier frequency fc of the VCO 18, the reference frequency fXTAL, the Doppler shift fd, and the frequency difference $\Delta f$ that is equal to the sum of the Doppler shift fd and the injection pulling frequency shift fb caused by environmental interference. A top half of Fig. 2 illustrates the value of the reference frequency fXTAL with respect to the carrier frequency fc. The carrier frequency fc is indicated with line 30. A sum of the carrier frequency fc and the frequency difference $\Delta f$ is indicated with line 32. A sum of the carrier frequency fc and the Doppler shift fd is indicated with line 34.

A bottom half of Fig. 2 illustrates the effects of subsampling, which effectively forms a relationship between the carrier frequency fc and the reference frequency fXTAL such that the carrier frequency fc is a multiple or fractional multiple of the reference frequency fXTAL. The far left side of the bottom of Fig. 2 isolates the Doppler shift fd and the frequency difference $\Delta f$ from the carrier frequency fc in order to show more clearly how the Doppler shift fd can be determined. The frequency difference $\Delta f$ is indicated with line 42, and the Doppler shift fd is indicated with line 44. Line 46 shows an example of a bandwidth of the loop filter 16 that can be selected for isolating the Doppler shift fd from the frequency difference $\Delta f$. So long as the loop filter 16 has a bandwidth greater than the size of the Doppler shift fd and less than the frequency difference $\Delta f$, the loop filter 16 can ensure that the Doppler shift fd is properly determined. Since typically the value of the Doppler shift fd is much less than that of both the injection pulling frequency shift fb caused by environmental interference and the summed value of the frequency difference $\Delta f$, the Doppler shift fd can be effectively isolated so long as the injection pulling frequency shift fb caused by environmental interference does not have a value very close to that of the reference frequency fXTAL. As stated above, in order to prevent aliasing effect, the reference frequency fXTAL should be greater than or equal to twice the frequency difference $\Delta f$.

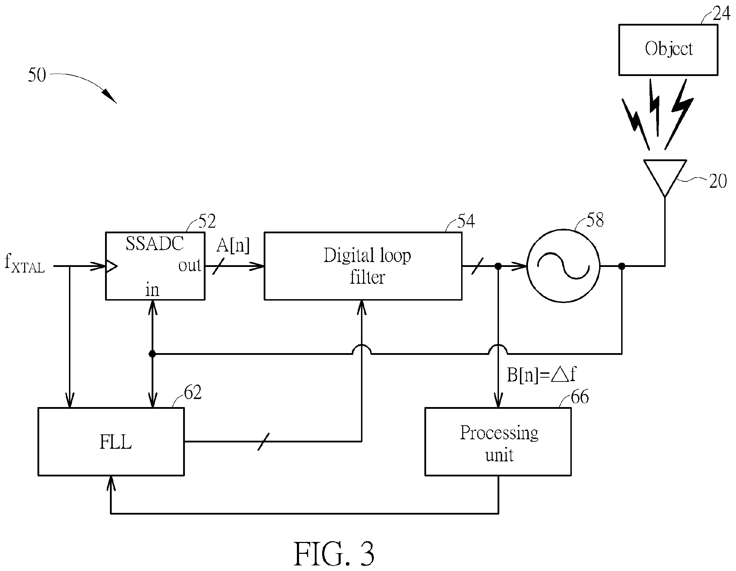

Please refer to Fig. 3. Fig. 3 illustrates a motion detector 50 according to a second example. The motion detector 50 of Fig. 3 is similar to the motion detector 10 of Fig. 1, but is created using primarily digital components. Only the differences between the motion detector 50 and the motion detector 10 will be described below. The SSPD 12 and the VCO 18 of the motion detector 10 are now respectively replaced with a subsampling analog-to-digital converter (SSADC) 52 and a digitally controlled oscillator (DCO) 58. The SSADC 52 receives the reference frequency fXTAL and an oscillation signal output from the DCO 58 and detects a phase difference between the oscillation signal and the reference frequency fXTAL at time periods indicated by the reference frequency fXTAL. The SSADC 52 outputs a phase detection digital output signal A[n] according to the detected phase difference, which is in turn input into a digital loop filter 54. The digital loop filter 54 converts the phase detection digital output signal A[n] into a digital control signal B[n] that is used for controlling the DCO 58. This digital control signal B[n] can be used to determine the frequency difference $\Delta f$ by a processing unit 66. Similar to the processing unit 26 of the motion detector 10, the processing unit 66 can also determine when it is necessary to turn on and off an FLL 62 and outputs a control signal to the FLL 62 for controlling when to turn on and turn off the FLL 62.

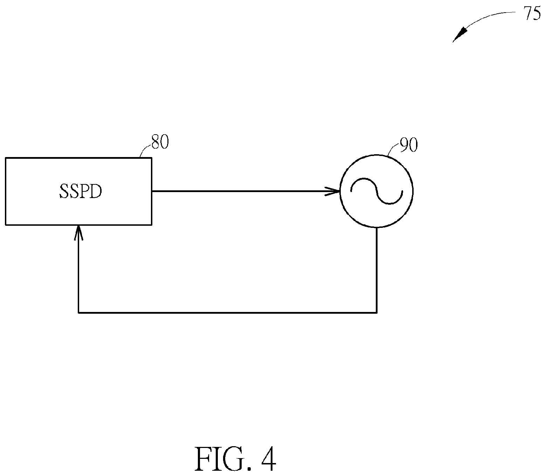

Please refer to Fig. 4. Fig. 4 illustrates a motion detector 75 depicting a generalized version of the first example and the second example. The motion detector 75 contains an SSPD 80 and a controllable oscillator 90. The SSPD 80 may be realized as either the SSPD 12 shown in Fig. 1 or the SSADC 52 shown in Fig. 3. The controllable oscillator 90 may be realized as either the VCO 18 shown in Fig. 1 or the DCO 58 shown in Fig. 3. Operation of the motion detector 75 is similar to that of the motion detectors 10 and 50 described in Fig. 1 and Fig. 3, respectively, and will not be repeated for the sake of brevity.

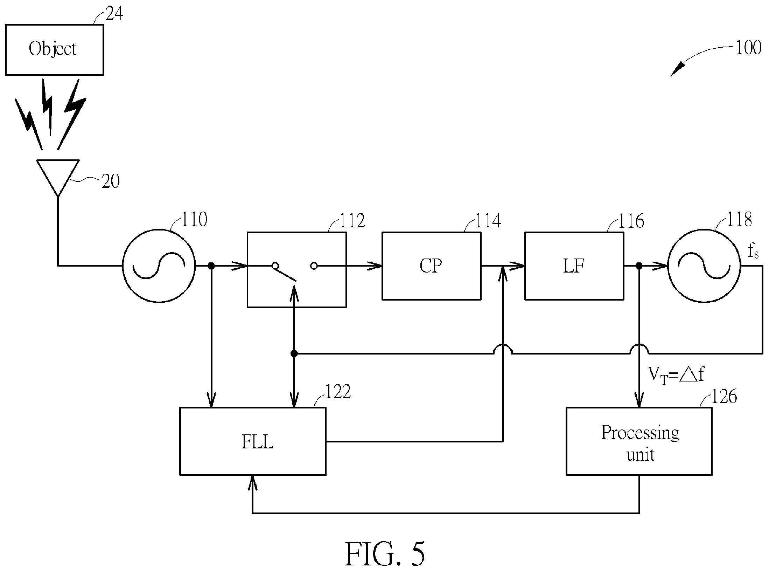

Please refer to Fig. 5. Fig. 5 illustrates a motion detector 100 according to a first embodiment of the present invention. Similar to the motion detector 10 of Fig. 1, the motion detector 100 is created using primarily analog components. The main difference is the motion detector 100 contains no crystal oscillator or other reference generator for providing the reference frequency fXTAL. Instead, the motion detector 100 comprises two different oscillators, including a second oscillator 110 (e.g. a high frequency oscillator 110) and a first oscillator 118 (e.g. a low frequency VCO 118). According to this embodiment of the present invention, the oscillation frequency of the high frequency oscillator 110 is higher than the oscillation frequency of the low frequency VCO 118, and the low frequency VCO 118 is a voltage-controlled oscillator. A high frequency oscillation signal of the high frequency oscillator 110 has a carrier frequency fc. The second wireless RF signal could be caused by the high frequency oscillation signal, for example, could be the high frequency oscillation signal. However, due to injection pulling, the frequency of the high frequency oscillation signal can be pulled to fc + Δf, where Δf is a frequency difference that is equal to a sum of the Doppler shift fd caused by the object 24 and an injection pulling frequency shift fb caused by environmental interference. The low frequency VCO 118 generates a low frequency oscillation signal fs according to a received control voltage. The high frequency oscillator 110 has better phase noise performance than that of the low frequency VCO 118. The low frequency VCO 118 could be less inexpensive than a crystal oscillator, and the lower frequency of the low frequency oscillation signal fs allows power savings.

The motion detector 100 further comprises an SSPD 112 having a first input for receiving the high frequency oscillation signal output from the high frequency oscillator 110, and a second input for receiving the low frequency oscillation signal fs. The SSPD 112 performs phase detection by comparing phase differences of the low frequency oscillation signal fs and the high frequency oscillation signal. The SSPD 112 samples the high frequency oscillation signal at a frequency controlled by the low frequency oscillation signal fs for performing the phase detection function. The motion detector 100 is designed such that a frequency of the high frequency oscillation signal is a multiple or fractional multiple of the frequency of the low frequency oscillation signal fs. Therefore, the SSPD 112 in effect provides the function of dividing the frequency of the high frequency oscillation signal into a lower frequency signal, and the SSPD 112 could use much less power than a traditional frequency divider of a PLL.

When the SSPD 112 detects the phase difference between the high frequency oscillation signal and the low frequency oscillation signal fs at time periods indicated by the low frequency oscillation signal fs, the SSPD 112 outputs a phase detection output signal to the charge pump 114 according to the detected phase difference. The charge pump 114 converts the phase detection output signal received from the SSPD 112 into an output current signal, and the loop filter 116 converts the output current signal into the control voltage used to control the low frequency VCO 118. The control voltage used to control the low frequency VCO 118 can be represented as a tuning voltage VT, which represents the frequency difference Δf. As in the motion detector 10, by providing the tuning voltage VT to a processing unit 126, it is possible to extract the Doppler shift fd caused by the object 24 while ignoring the effects of the injection pulling frequency shift fb.

The FLL 122 receives as inputs both the high frequency oscillation signal and the low frequency oscillation signal fs. The FLL 122 can be controllably turned on and off, and the FLL 122 assists the SSPD 112 with detecting a phase difference between the high frequency oscillation signal and the low frequency oscillation signal fs when the FLL 122 is turned on. The FLL 122 can modify the output current signal that is provided from the charge pump 114 into the loop filter 116 for helping to control the function of the loop filter 116 when the SSPD 112 is unable to easily detect the phase difference between the high frequency oscillation signal and the low frequency oscillation signal fs. The processing unit 126 controls when to turn on and off the FLL 122, and the FLL 122 is usually kept powered off for the purpose of power savings. The processing unit 126 should ensure that the frequency of the low frequency oscillation signal fs is greater than or equal to twice the frequency difference Δf.

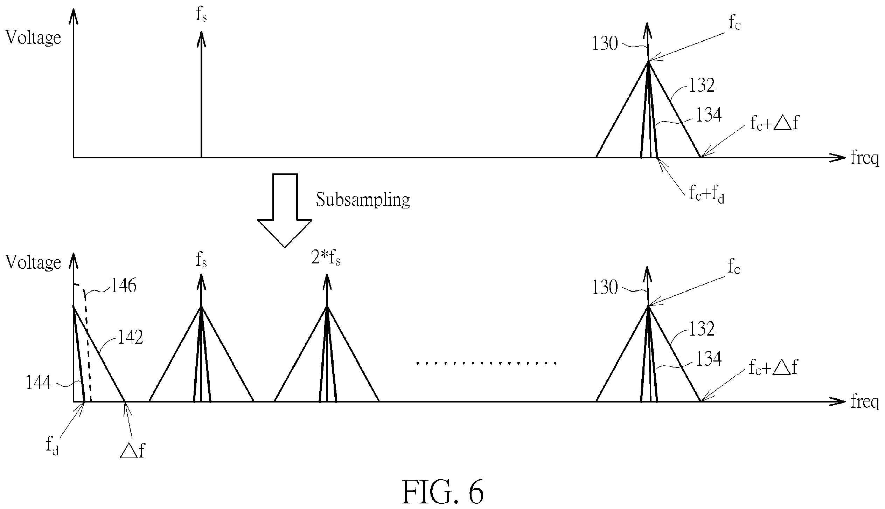

Please refer to Fig. 6. Fig. 6 illustrates relative frequencies of the carrier frequency fc of the VCO 18, the low frequency oscillation signal fs, the Doppler shift fd, and the frequency difference Δf that is equal to the sum of the Doppler shift fd and the injection pulling frequency shift fb caused by environmental interference. Fig. 6 is similar to Fig. 2, but the reference frequency fXTAL is replaced with the low frequency oscillation signal fs since the low frequency oscillation signal fs is used for sampling the high frequency oscillation signal in the motion detector 100. A top half of Fig. 6 illustrates the value of the low frequency oscillation signal fs with respect to the carrier frequency fc. The carrier frequency fc is indicated with line 130. A sum of the carrier frequency fc and the frequency difference Δf is indicated with line 132. A sum of the carrier frequency fc and the Doppler shift fd is indicated with line 134.

A bottom half of Fig. 6 illustrates the effects of subsampling, which effectively forms a relationship between the carrier frequency fc and the low frequency oscillation signal fs such that the carrier frequency fc is a multiple or fractional multiple of the low frequency oscillation signal fs. The far left side of the bottom of Fig. 6 isolates the Doppler shift fd and the frequency difference Δf from the carrier frequency fc in order to show more clearly how the Doppler shift fd can be determined. The frequency difference Δf is indicated with line 142, and the Doppler shift fd is indicated with line 144. Line 146 shows an example of a bandwidth of the loop filter 116 that can be selected for isolating the Doppler shift fd from the frequency difference Δf. In order to prevent aliasing effect, the low frequency oscillation signal fs should be greater than or equal to twice the frequency difference Δf.

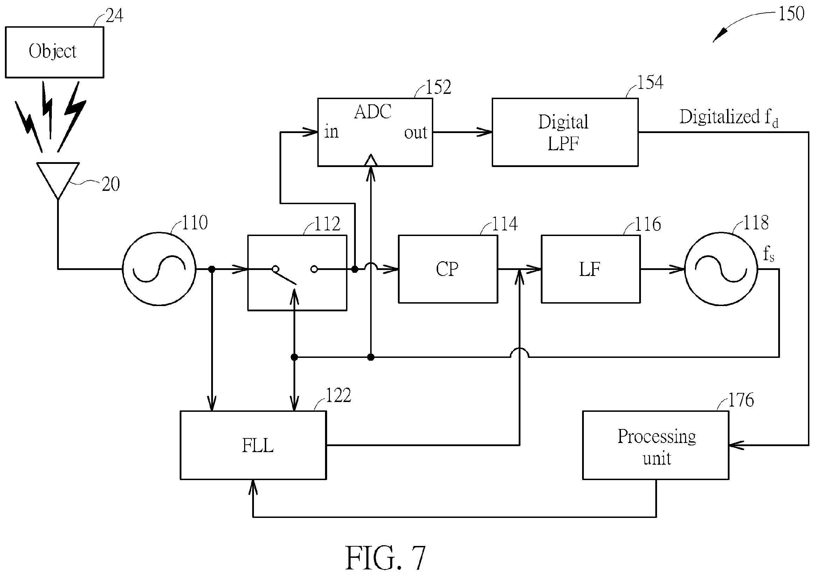

Please refer to Fig. 7. Fig. 7 illustrates a motion detector 150 according to a second embodiment of the present invention. Similar to the motion detector 100 of Fig. 5, the motion detector 150 is created using primarily analog components. The main difference is the motion detector 150 contains an analog-to-digital converter (ADC) 152 and a digital low-pass filter (LPF) 154. The ADC 152 receives a clock input from the low frequency oscillation signal fs, and converts the phase detection output signal output from the SSPD 112 into a phase detection digital output signal at time periods indicated by the low frequency oscillation signal fs. The digital LPF 154 then converts the phase detection digital output signal into a digitalized version of the Doppler shift fd, which is in turn transmitted to a processing unit 176. The processing unit 176 also controls operation of the FLL 122, as explained with respect to the motion detector 100.

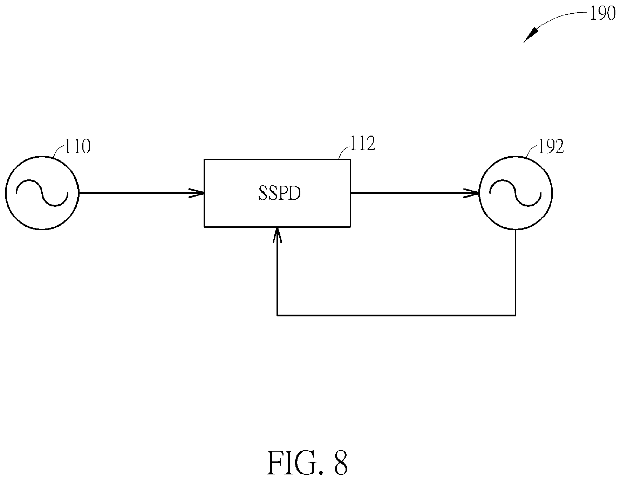

Please refer to Fig. 8. Fig. 8 illustrates a motion detector 190 depicting a generalized version of the first embodiment and the second embodiment of the present invention. The motion detector 190 contains the high frequency oscillator 110, the SSPD 112, and a low frequency controllable oscillator 192. The low frequency controllable oscillator 192 can be realized as the low frequency VCO 118. Operation of the motion detector 190 is similar to that of the motion detectors 100 and 150 described in Fig. 5 and Fig. 7, respectively, and will not be repeated for the sake of brevity.

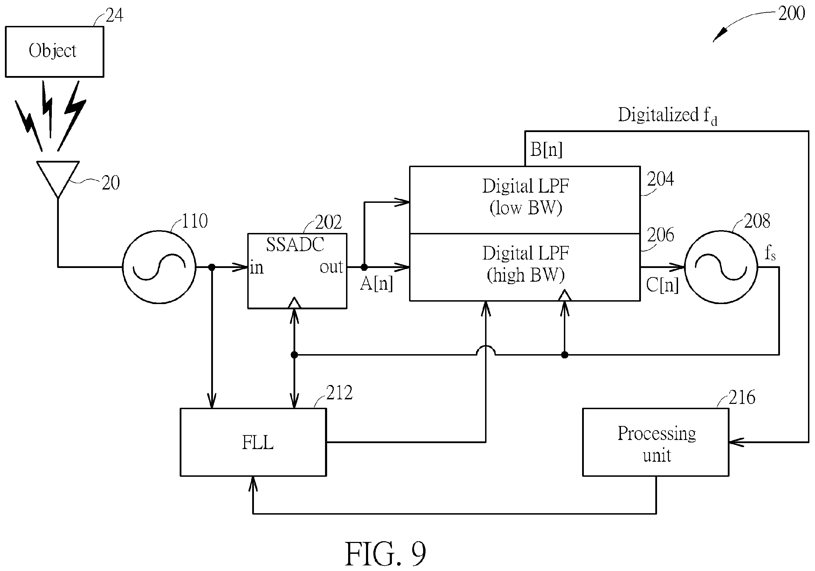

Please refer to Fig. 9. Fig. 9 illustrates a motion detector 200 according to a third embodiment of the present invention. Similar to the motion detector 100 of Fig. 5, the motion detector 200 contains the high frequency oscillator 110 and another low frequency oscillator. However, the motion detector 200 is created using primarily digital components. The low frequency VCO 118 of the motion detector 100 is replaced with a low frequency DCO 208 that is controlled with a digital control signal C[n]. The low frequency DCO 208 generates a low frequency oscillation signal fs according to the digital control signal C[n]. The SSPD 112 of the motion detector 100 is replaced with an SSADC 202. The SSADC 202 receives the low frequency oscillation signal fs and the high frequency oscillation signal output from the high frequency oscillator 110, and detects a phase difference between the high frequency oscillation signal and the low frequency oscillation signal fs at time periods indicated by the low frequency oscillation signal fs. The SSADC 202 outputs a phase detection digital output signal A[n] according to the detected phase difference, which is in turn input into a both a digital LPF 204 with low bandwidth and a digital LPF 206 with high bandwidth. The digital LPF 206 receives a clock input from the low frequency oscillation signal fs, and converts the phase detection digital output signal A[n] into the digital control signal C[n] that is used for controlling the DCO 208. The digital LPF 204 converts the phase detection digital output signal A[n] into a motion output signal B[n] representing a digitalized version of the Doppler shift fd, which is in turn transmitted to a processing unit 216. The processing unit 216 also controls operation of an FLL 212 by determining when it is necessary to turn on and off an FLL 212, and outputs a control signal to the FLL 212 for controlling when to turn on and turn off the FLL 212. The output of the FLL 212 is input into the digital LPF 206 for helping to adjust an output of the digital LPF 206, and the output of the FLL 212 is not input into the digital LPF 204.

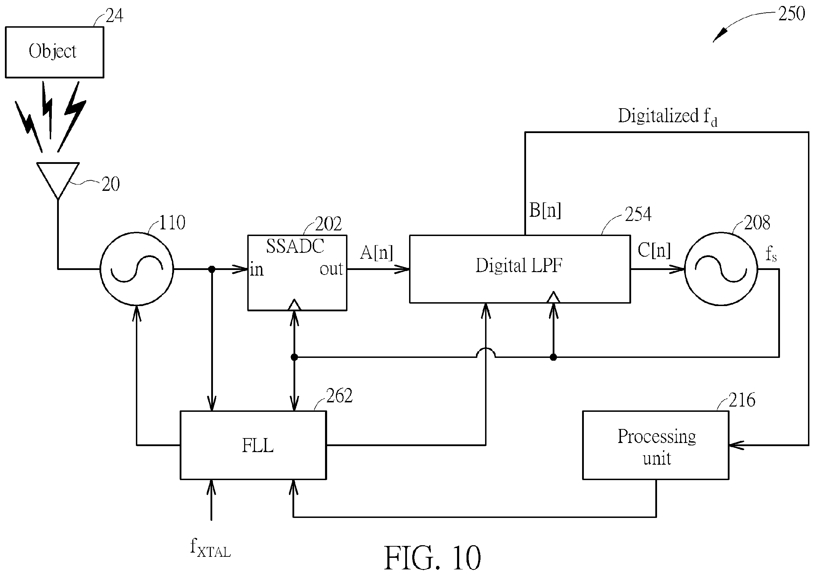

Please refer to Fig. 10. Fig. 10 illustrates a motion detector 250 according to a fourth embodiment of the present invention. Similar to the motion detector 200 of Fig. 9, the motion detector 250 differs in that the digital LPF 204 and the digital LPF 206 are replaced with a single digital LPF 254 and in that an FLL 262 receives a reference frequency fXTAL from a crystal oscillator or other reference generator. The SSADC 202 outputs the phase detection digital output signal A[n] according to the detected phase difference between the high frequency oscillation signal and the low frequency oscillation signal fs at time periods indicated by the low frequency oscillation signal fs. This phase detection digital output signal A[n] is input into the digital LPF 254. The digital LPF 254 converts the phase detection digital output signal A[n] into the digital control signal C[n] that is used for controlling the DCO 208, and also converts the phase detection digital output signal A[n] into a motion output signal B[n] representing a digitalized version of the Doppler shift fd, which is in turn transmitted to the processing unit 216. The relationship between the reference frequency fXTAL, the low frequency oscillation signal fs, and the carrier frequency fc output by the high frequency oscillator 110 is explained as follows. The low frequency oscillation signal fs is a first multiple or fractional multiple M of the reference frequency fXTAL. The carrier frequency fc is a second multiple N of the low frequency oscillation signal fs. Thus, the carrier frequency fc is equal to M*N the reference frequency fXTAL, where M is either an integer or a fractional value greater than 1, and N is either an integer or a fractional value greater than 1 that may be equal to or different to the value of M. In this embodiment, a lower cost and lower frequency (such as 32.768 kHz) crystal oscillator is enough to calibrate both the low frequency oscillation signal fs and the carrier frequency fc. As in other embodiments, in order to prevent aliasing effect, the low frequency oscillation signal fs should be greater than or equal to twice the frequency difference $\Delta f$.

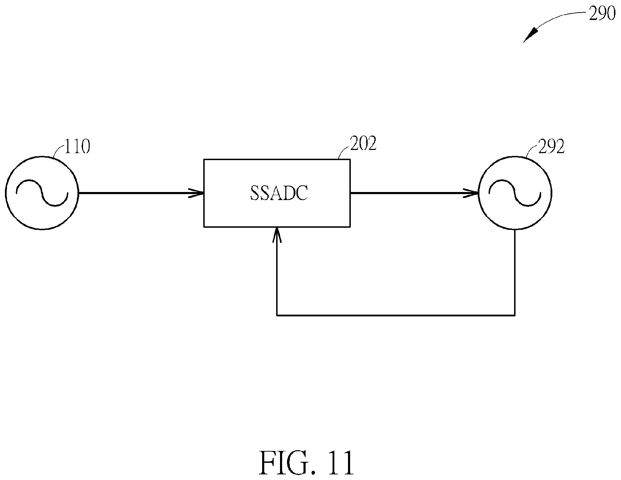

Please refer to Fig. 11. Fig. 11 illustrates a motion detector 290 depicting a generalized version of the fifth embodiment and the sixth embodiment of the present invention. The motion detector 290 contains the high frequency oscillator 110, the SSADC 202, and a low frequency controllable oscillator 292. The low frequency controllable oscillator 292 can be realized as the low frequency DCO 208. Operation of the motion detector 290 is similar to that of the motion detectors 200 and 250 described in Fig. 9 and Fig. 10, respectively, and will not be repeated for the sake of brevity.

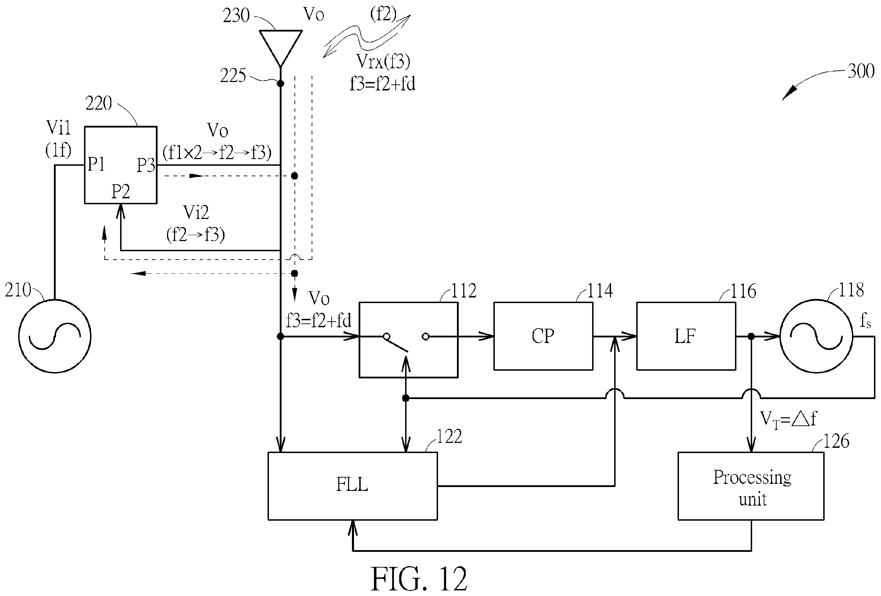

FIG. 12 illustrates a motion detector 300 according to another embodiment of the present invention. Similar to the motion detector 100 of FIG. 5, except that the high frequency oscillator 110 and the transceiver 20 of FIG. 5 are replaced by a second oscillator 210, a frequency multiplier 220, a transceiving node 225, and a transceiver 230. The transceiver 230 may be a device used to transmit and receive signals, for example, an antenna or a signal sensor. The second oscillator 210 is used to generate an injection signal Vi1 having a frequency f1. The frequency multiplier 220 includes injection terminals P1 and P2, and an output terminal P3. The injection terminal P1 is coupled to the second oscillator 210, and used to receive the injection signal Vi1. The output terminal P3 is used to output an output signal Vo (i.e. the high frequency oscillation signal). The injection terminal P2 is used to receive an injection signal Vi2 having a frequency f2. The frequency multiplier 220 may output the output signal Vo at a frequency substantially equal to a multiple of the frequency f1 (e.g. 2f1, 3f1, etc.) by injection locking, and pulls the output signal Vo to the frequency f2 by injection pulling. The frequency multiplier 220 may be a double, triple or n-times frequency multiplier, where n is a positive integer. The transceiver 230 is coupled to the output terminal P3 and the injection terminal P2 of the frequency multiplier 220, and used to transmit the output signal Vo, and receive a received signal Vrx having a frequency f3. The received signal Vrx is used to update the injection signal Vi2. The SSPD 112 (or SSADC 112) and the FLL 122 are coupled to the output terminal P3 of the frequency multiplier 220,

For example, if the injection signal Vi2 has the frequency f2 (e.g. (10G+300)Hz), the frequency of the output signal Vo may be pulled from the double of the frequency f1 (e.g. 5G Hz), that is (f1×2) (e.g. 10GHz), to the frequency f2 (e.g. to (10G+300)Hz from 10G Hz) by injection pulling. The transceiver 230 (e.g. an antenna) may transmit the output signal Vo having the frequency f2 (e.g. (10G+300) Hz) outward. When detecting a detected object (e.g. a vehicle), the received signal Vrx may be reflected to the transceiver 230. The received signal Vrx may have the frequency f3. The relation of the frequency f3 of the received signal Vrx and the frequency f2 of the output signal Vo may be described by following equation α:

$$f3 = f2 + fd \ \ldots\ldots\ldots.. \ (\alpha);$$

The frequency fd may be a difference frequency generated by the Doppler effect. The difference frequency fd may be positive if the detected object is moving forward the motion detector 300, and the difference frequency fd may be negative if the detected object is moving away from the motion detector 300. After the transceiver 230 receives the received signal Vrx having the frequency f3 (i.e. (f2+fd), for example, if fd is 100 Hz, and f2 is (10G+300) Hz, f3 may be (10G+300+100) Hz, that is (10G+400) Hz), the received signal Vrx (e.g. with a frequency of (10G+400) Hz) may be used to update the injection signal Vi2. Hence, the frequency of the injection signal Vi2 may be updated from the frequency f2 (e.g. (10G+300) Hz) to the frequency f3 (e.g. (10G+400) Hz). After the injection signal Vi2 is updated to the frequency f3 (e.g. (10G+400) Hz), the output signal Vo may be pulled to the frequency f3 (e.g. (10G+400) Hz) at the frequency multiplier 220 by injection pulling. Comparing with the oscillation source 110 operated at a high frequency (e.g. 10G Hz) in the previous embodiment, the operation frequency of the second oscillator 210 of the embodiment illustrated by FIG. 12 may be decreased to 50% or even lower according to the multiplier of the frequency multiplier 220, and power consumption may be effectively reduced.

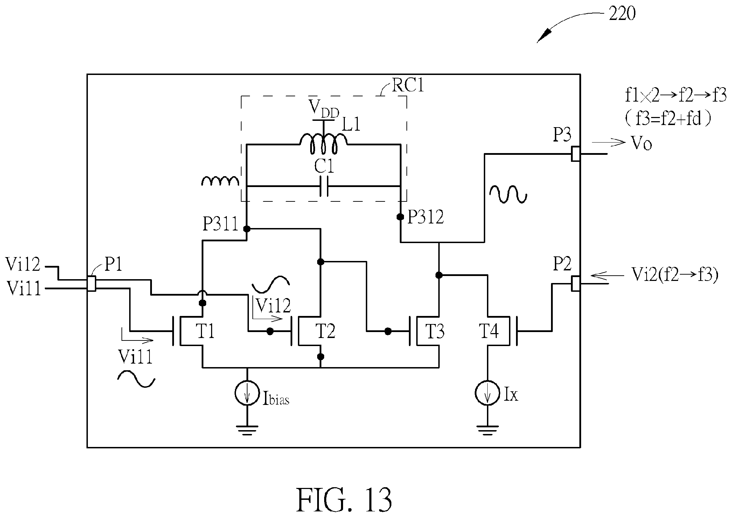

FIG. 13 illustrates the frequency multiplier 220 according to an embodiment of the present invention. The frequency multiplier 220 includes a resonant circuit RC1 and transistors T1, T2, T3 and T4. The resonant circuit RC1 may be a tank circuit operated at a multiple (e.g. double) of the frequency f1, and includes at least a capacitor C1, at least an inductor L1, a first terminal P311, and a second terminal P312 coupled the output terminal P3 of the frequency multiplier 220. The inductor L1 may be coupled to a voltage source VDD according to an embodiment. The transistor T1 includes a gate terminal coupled to the injection terminal P1 and used to receive a first phase portion Vi11 of the injection signal Vi1, a first terminal coupled to the first terminal P311 of the resonant circuit RC1, and a second terminal coupled to a bias current source Ibias. The transistor

T2 includes a gate terminal coupled to the injection terminal P1 and used to receive a second phase portion Vi12 of the injection signal Vi1, a first terminal coupled to the first terminal P311 of the resonant circuit RC1, and a second terminal coupled to the bias current source Ibias. The transistor T3 includes a gate terminal coupled to the first terminal P311 of the resonant circuit RC1, a first terminal coupled to the second terminal P312 of the resonant circuit RC1, and a second terminal coupled to the bias current source Ibias. The transistor T4 includes a gate terminal coupled to the injection terminal P2 and used to receive the injection signal Vi2, a first terminal coupled to the second terminal P312 of the resonant circuit RC1, and a second terminal coupled to a current source Ix. According to an embodiment of the present invention, the current source Ix and the bias current source Ibias may be of an identical current source. FIG. 13 may be one of the designs of the frequency multiplier 220 rather than being used to limit the internal structure of the frequency multiplier 220, and a designer may adjust the internal circuit of the frequency multiplier 220 according to requirement of the product.

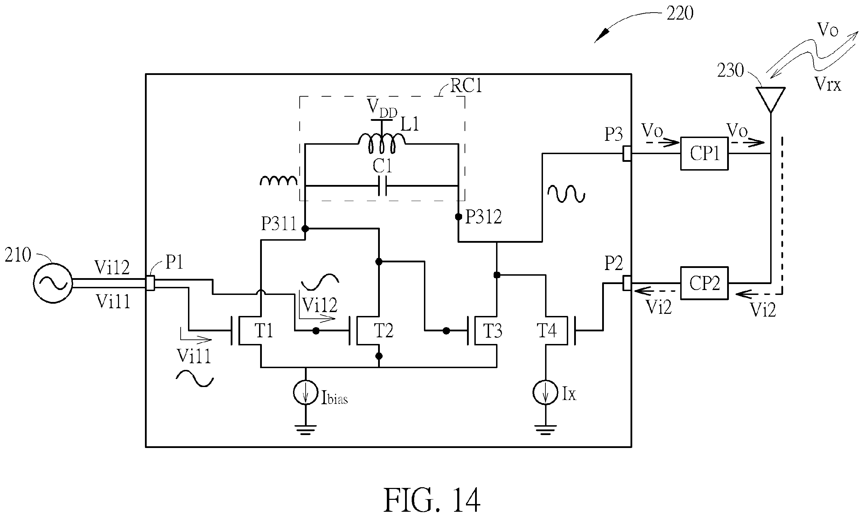

FIG. 14 illustrates that the frequency multiplier 220 of FIG. 13 is coupled to the oscillation source 210 and transceiver 230 according to an embodiment of the present invention. According to FIG. 14, since the injection signal Vi1 is formed by the first phase portion Vi11 and second phase portion Vi12, the signals Vi11 and Vi12 may be input to the transistors T1 and T2 respectively. According to another embodiment, if the injection signal Vi1 is a single signal, an inverter may be coupled to the gate terminal of the transistor T2 so as to obtain a signal with a reversed phase of the injection signal Vi1. According to embodiment shown in FIG. 14, a coupling unit CP1 may be disposed between the transceiver 230 and the output terminal P3 of the frequency multiplier 220, and another coupling unit CP2 may be disposed between and the transceiver 230 and the injection terminal P2 of the frequency multiplier 220. The coupling unit CP1/CP2 may include a power amplifier, a low noise amplifier and/or a capacitor. A designer may determine whether to dispose the coupling unit CP1 and/or the coupling unit CP2, and determine the sort of the coupling unit CP1/CP2 according to design requirement or result of measurement so as to improve the effect of detection. For example, a smaller capacitor may be chosen for signals of higher frequency.

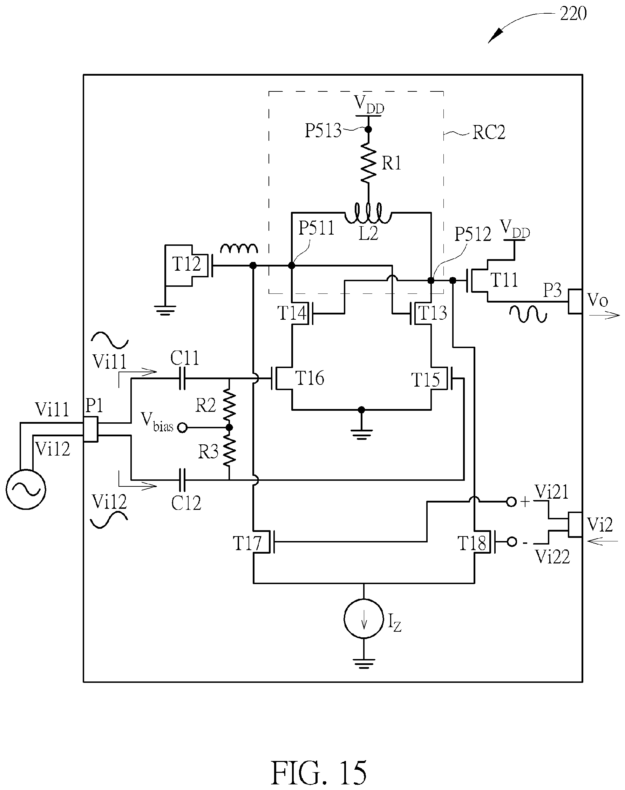

FIG. 15 illustrates the frequency multiplier 220 according to another embodiment of the present invention. The frequency multiplier 220 may include a resonant circuit RC2, transistors T11-T18, resistors R2-R3 and capacitors C11-C12. The resonant circuit RC2 may be operated at a multiple of the frequency f1, and includes a resistor R1, an inductor L2, a voltage terminal P513 coupled to a voltage source VDD, a first terminal P511 and a second terminal P512. The voltage terminal P513 may couple to the middle of the inductor L2 through the resistor R1. The transistor T11 may include a gate terminal coupled to the second terminal P512 of the resonant circuit RC2, a first terminal coupled to the voltage source VDD, and a second terminal coupled to the output terminal P3 of the frequency multiplier 220. The transistor T12 may include a gate terminal coupled to the first terminal P511 of the resonant circuit RC2, a first terminal coupled to a ground terminal, and a second terminal coupled to the ground terminal. The transistor T13 may include a gate terminal coupled to the first terminal P511 of the resonant circuit RC2, a first terminal coupled to the second terminal P512 of the resonant circuit RC2, and a second terminal. The transistor T14 may include a gate terminal coupled to the second terminal P512 of the resonant circuit RC2, a first terminal coupled to the first terminal P511 of the resonant circuit RC2, and a second terminal. The transistor T15 may include a gate terminal, a first terminal coupled to the second terminal of the transistor T13, and a second terminal coupled to the ground terminal. The transistor T16 may include a gate terminal, a first terminal coupled to the second terminal of the transistor T14, and a second terminal coupled to the second terminal of the transistor T15 and the ground terminal. The resistor R2 may include a first terminal coupled to the gate terminal of the transistor T16, and a second terminal coupled to a bias voltage source Vbias. The resistor R3 may include a first terminal coupled to the bias voltage source Vbias, and a second terminal coupled to the gate terminal of the transistor T15. The capacitor C11 may include a first terminal coupled to the injection terminal P1 and used to receive the first phase portion Vi11 of the injection signal Vi1, and a second terminal coupled to the first terminal of the resistor R1. The capacitor C12 may include a first terminal coupled to the injection terminal P1 and used to receive the second phase portion Vi12 of the injection signal Vi1, and a second terminal coupled to the gate terminal of the transistor T15. The transistor T17 may include a first terminal coupled to the gate terminal of the transistor T12, a gate terminal coupled to the injection terminal P2 and used to receive the injection signal Vi2, and a second terminal coupled to a current source Iz. The transistor T18 includes a first terminal coupled to the gate terminal of the transistor T11, a gate terminal coupled to the second injection terminal P2 and configured to receive the second injection signal Vi2, and a second terminal coupled to the current source Iz. The current source Iz may be coupled to the ground terminal. According to an embodiment of the present invention, the gate terminal of the transistor T17 may be used to receive a first phase portion Vi21 of the injection signal Vi2, and the gate terminal of the transistor T18 may be used to receive a second phase portion Vi22 of the injection signal Vi2.

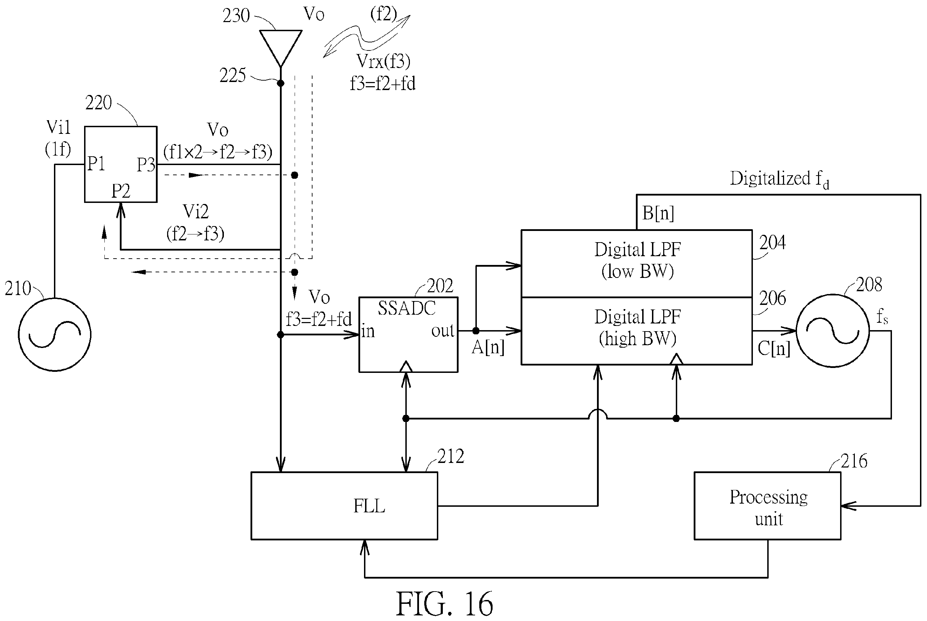

Fig. 16 illustrates a motion detector 400 according to another embodiment of the present invention similar to the motion detector 200 of Fig. 9 except that the high frequency oscillator 110 and the transceiver 20 of FIG. 9 are replaced by a second oscillator 210, a frequency multiplier 220, a transceiving node 225, and a transceiver 230. Functionality and structures of the various components have been described and are not repeated here for brevity.

In summary, the embodiments of present invention try to avoid the need for a frequency divider that is common in other motion detectors. By lowering the sampling rate using subsampling, the overall power consumption of the motion detector could be lowered considerably without sacrificing the accuracy of detection.

## Claims

1. A subsampling motion detector (100, 150, 300) configured to detect motion information of an object (24) under measurement, the subsampling motion detector (100, 150, 300) receiving a first wireless radio frequency signal and transmitting a second wireless radio frequency signal, the first wireless radio frequency signal being generated by reflecting the second wireless radio frequency signal from the object, the subsampling motion detector (100, 150, 300) **characterized by:**

   a first oscillator (118) generating a low frequency oscillation signal according to a control signal;
   a second oscillator (110, 210) outputting a high frequency oscillation signal, wherein the first wireless radio frequency signal is injected to the second oscillator (110, 210) for controlling the second oscillator (110, 210) through injecting locking; and
   a subsampling phase detector (112) receiving the high frequency oscillation signal and the low frequency oscillation signal and detecting a phase difference between the high frequency oscillation signal and the low frequency oscillation signal at time periods indicated by the low frequency oscillation signal, the subsampling phase detector (112) outputting a phase detection output signal according to the detected phase difference, the control signal being generated according to the phase detection output signal output from the subsampling phase detector (112), and the motion information of the object (24) being calculated according to the phase detection output signal;

wherein the high frequency oscillation signal received by the subsampling phase detector (112) is controlled by the first wireless radio frequency signal through injecting locking, and the second wireless radio frequency signal is caused by the high frequency oscillation signal.

2. The subsampling motion detector (300) of claim 1, further

**characterized by**

a frequency multiplier (220) serially coupled between the second oscillator (210) and the subsampling phase detector (112), comprising:

a first injection terminal (P1) configured to receive an injection signal (Vi1) having a first frequency output by the second oscillator (210);
an output terminal (P3) configured to output the high frequency oscillation signal (Vo); and
a second injection terminal (P2) configured to receive the first wireless radio frequency signal (Vi2) having a second frequency;

wherein the frequency multiplier (220) is configured to output the high frequency oscillation signal (Vo) at a frequency substantially equal to a multiple of the first frequency by injection locking, and pulls the high frequency oscillation signal (Vo) to the second frequency by injection pulling.

3. The subsampling motion detector (100, 150, 300) of any of claims 1-2, further **characterized in that** the first oscillator (118) is a voltage-controlled oscillator and the control signal is a control voltage, the subsampling motion detector (100, 150, 300) further comprising:

a charge pump (114) converting the phase detection output signal received from the subsampling phase detector (112) into an output current signal; and
a loop filter (116) converting the output current signal into the control voltage.

4. The subsampling motion detector (100, 150, 200, 250, 300, 400) of any of claims 1-3, further **characterized by** a frequency lock loop (122, 212) receiving the low frequency oscillation signal and the high frequency oscillation signal, the frequency lock loop (122, 212) controllably turned on and off, and the frequency lock loop assisting the subsampling phase detector (112, 202) with detecting the phase difference between the high frequency oscillation signal and the low frequency oscillation signal when the frequency lock loop (112, 202) is turned on.

5. The subsampling motion detector (100, 150, 200, 250, 300, 400) of any of claims 1-4, further **characterized in that** the frequency of the low frequency oscillation signal is greater than or equal to twice a frequency difference between the first wireless radio frequency and the frequency of the high frequency oscillation signal, the frequency difference being equal to a sum of a Doppler frequency shift caused by the object and an environmental injection pulling frequency shift.

6. The subsampling motion detector (100, 150, 200, 250, 300, 400) of any of claims 1-5, further **characterized by** a transceiving node for receiving the first wireless radio frequency signal and transmitting the second wireless radio frequency signal, wherein the second oscillator (110, 210) is electrically connected to the transceiving node and outputs the high frequency oscillation signal to the transceiving node, and the first wireless radio frequency signal received by the transceiving node is injected to the second oscillator (110).

7. A subsampling motion detector (200, 250, 400) configured to detect motion information of an object (24) under measurement, the subsampling motion detector (200) receiving a first wireless radio frequency signal and transmitting a second wireless radio frequency signal, the first wireless radio frequency signal being generated by reflecting the second wireless radio frequency signal from the object (24), the subsampling motion detector (200) comprising:

a first oscillator (208) generating a low frequency oscillation signal according to a control signal;
a second oscillator (110) outputting a high frequency oscillation signal, wherein the first wireless radio frequency signal is injected to the second oscillator (110) for controlling the second oscillator (110) through injecting locking; and
a subsampling analog-to-digital converter (202) receiving the high frequency oscillation signal and the low frequency oscillation signal and detecting a phase difference between the high frequency oscillation signal and the low frequency oscillation signal at time periods indicated by the low frequency oscillation signal, the subsampling analog-to-digital converter (202) outputting a phase detection digital output signal according to the detected phase difference, the control signal being generated according to the phase detection digital output signal output from the subsampling analog-to-digital converter (202), and the motion information of the object (24) being calculated according to the phase detection digital output signal;

wherein the high frequency oscillation signal received by the subsampling analog-to-digital converter (202) is controlled by the first wireless radio frequency signal through injecting locking, and the second wireless radio frequency signal is caused by the high frequency oscillation signal.

8. The subsampling motion detector (300) of claim 7, further **characterized by**

a frequency multiplier (220) serially coupled between the second oscillator (210) and the subsampling analog-to-digital converter (202), comprising:

a first injection terminal (P1) configured to receive the injection signal (Vi1) having a first frequency output by the second oscillator (210);
an output terminal (P3) configured to output the high frequency oscillation signal (Vo); and
a second injection terminal (P2) configured to receive the first wireless radio frequency signal (Vi2) having a second frequency;

wherein the frequency multiplier (220) is configured to output the high frequency oscillation signal (Vo) at a frequency substantially equal to a multiple of the first frequency by injection locking, and pulls the high frequency oscillation signal (Vo) to the second frequency by injection pulling.

9. The subsampling motion detector (200, 250, 400) of any of claims 7-8, further **characterized in that** the first oscillator (208) is a digitally controlled oscillator and the control signal is a digital control signal, and the subsampling motion detector (200) further comprises:

a digital low-pass filter (204, 206) converting the phase detection digital output signal into the digital control signal, the digital low-pass filter (204, 206) comprising:

a low bandwidth digital low-pass filter (204) converting the phase detection digital output signal into a motion output signal representing the motion information of the object (24); and
a high bandwidth digital low-pass filter (206) converting the phase detection digital output signal into the digital control signal.

10. The subsampling motion detector (100, 150, 200, 250, 300, 400) of any of claims 7-9, further **characterized by** a frequency lock loop (122, 212) receiving the low frequency oscillation signal and the high frequency oscillation signal, the frequency lock loop (122, 212) controllably turned on and off, and the frequency lock loop assisting the subsampling phase detector (112, 202) with detecting the phase difference between the high frequency oscillation signal and the low frequency oscillation signal when the frequency lock loop (112, 202) is turned on.

11. The subsampling motion detector (100, 150, 200, 250, 300, 400) of any of claims 7-10, further **characterized in that** the frequency of the low frequency oscillation signal is greater than or equal to twice a frequency difference between the first wireless radio frequency and the frequency of the high frequency oscillation signal, the frequency difference being equal to a sum of a Doppler frequency shift caused by the object and an environmental injection pulling frequency shift.

12. The subsampling motion detector (100, 150, 200, 250, 300, 400) of any of claims 7-11, further **characterized by** a transceiving node for receiving the first wireless radio frequency signal and transmitting the second wireless radio frequency signal, wherein the second oscillator (110, 210) is electrically connected to the transceiving node and outputs the high frequency oscillation signal to the transceiving node, and the first wireless radio frequency signal received by the transceiving node is injected to the second oscillator (110).

**Patentansprüche**

1. Unterabtastung eines Bewegungsdetektors (100, 150, 300), der angepasst ist, die Bewegungsinformation eines Objekts (24) während der Messung zu erfassen, wobei die Unterabtastung eines Bewegungsdetektors (100, 150, 300) ein erstes drahtloses Funkfrequenzsignal empfängt und ein zweites drahtloses Funkfrequenzsignal sendet, wobei das erste drahtlose Funkfrequenzsignal durch Reflektieren des zweiten drahtlosen Funkfrequenzsignals an dem Objekt entsteht, wobei die Unterabtastung eines Bewegungsdetektors (100, 150, 300) **gekennzeichnet ist durch**:

einen ersten Oszillator (118), der ein niederfrequentes Oszillationssignal gemäß einem Steuersignal erzeugt;
einen zweiten Oszillator (110, 210), der ein hochfrequentes Oszillationssignal ausgibt, wobei das erste drahtlose Funkfrequenzsignal in den zweiten Oszillator (110, 210) injiziert wird, um den zweiten Oszillator (110, 210) mittels Injection Locking zu steuern; und einen Unterabtastungsphasendetektor (112), der das hochfrequente Oszillationssignal und das niederfrequente Oszillationssignal empfängt und einen Phasenunterschied zwischen dem hochfrequenten Oszillationssignal und dem niederfrequenten Oszillationssignal zu Zeitpunkten erfasst, die **durch** das niederfrequente Oszillationssignal angezeigt werden, wobei der Unterabtastungsphasendetektor (112) ein Phasenerfassungsausgangssignal gemäß dem erfassten Phasenunterschied ausgibt, wobei das Steuersignal gemäß der Ausgabe des Phasenerfassungsausgangssignals von dem Unterabtastungsphasendetektor (112) erzeugt wird, und wobei die Bewegungsinformation des Objekts (24) gemäß dem Phasenerfassungsausgangssignal berechnet wird; wobei das von dem Unterabtastungsphasendetektor (112) empfangene hochfrequente Oszillationssignal **durch** das erste drahtlose Funkfrequenzsignal mittels Injection Locking gesteuert wird, und das zweite drahtlose Funkfrequenzsignal von dem hochfrequenten Oszillationssignal verursacht wird.

2. Unterabtastung eines Bewegungsdetektors (300) nach Anspruch 1, ferner **gekennzeichnet durch** einen Frequenzmultiplikator (220), der zwischen dem zweiten Oszillator (210) und dem Unterabtastungsphasendetektor (112) in Reihe geschaltet ist, umfassend:

einen ersten Injektionsanschluss (P1), der angepasst ist, ein Injektionssignal (Vi1) zu erhalten, das einen ersten Frequenzausgang an dem zweiten Oszillator (210) aufweist; einen Ausgangsanschluss (P3), der angepasst ist, das hochfrequente Oszillationssignal (Vo) auszugeben; und einen zweiten Injektionsanschluss (P2), der angepasst ist, das erste drahtlose Funkfrequenzsignal (Vi2) mit einer zweiten Frequenz zu empfangen; wobei der Frequenzmultiplikator (220) angepasst ist, das hochfrequente Oszillationssignal (Vo) in einer Frequenz mittels Injection Locking auszugeben, die im Wesentlichen gleich zu mehreren der ersten Frequenzen ist, und Ziehen des hochfrequenten Oszillationssignals (Vo) zur zweiten Frequenz mittels Injection Pulling.

3. Unterabtastung eines Bewegungsdetektors (100, 150, 300) nach einem der Ansprüche 1-2, ferner **dadurch gekennzeichnet, dass** der erste Oszillator (118) ein spannungsgesteuerter Oszillator ist und das Steuersignal eine Steuerspannung ist, wobei die Unterabtastung eines Bewegungsdetektors (100, 150, 300) ferner umfasst:

eine Ladepumpe (114), die das von dem Unterabtastungsphasendetektor (112) erhaltene Phasenerfassungsausgangssignal in ein Ausgangsstromsignal wandelt; und einen Loopfilter (116), der das Ausgangsstromsignal in die Steuerspannung wandelt.

4. Unterabtastung eines Bewegungsdetektors (100, 150, 200, 250, 300, 400) nach einem der Ansprüche 1-3, ferner **gekennzeichnet durch** einen Frequency Locked Loop (122, 212), der das niederfrequente Oszillationssignal und das hochfrequente Oszillationssignal empfängt, wobei der Frequency Locked Loop (122, 212) steuerbar ein und ausgeschaltet wird, und wobei der Frequency Locked Loop dem Unterabtastungsphasendetektor (112, 202) beim Erfassen des Phasenunterschieds zwischen dem hochfrequenten Oszillationssignal und dem niederfrequenten Oszillationssignal hilft, wenn der Frequency Locked Loop (112, 202) eingeschaltet ist.

5. Unterabtastung eines Bewegungsdetektors (100, 150, 200, 250, 300, 400) nach einem der Ansprüche 1-4, ferner **dadurch gekennzeichnet, dass** die Frequenz des niederfrequenten Oszillationssignals größer ist als oder gleich zweimal einem Frequenzunterschied zwischen der ersten drahtlosen Funkfrequenz und der Frequenz des hochfrequenten Oszillationssignals, wobei der Frequenzunterschied gleich einer Summe aus einer Doppler Frequenzverschiebung, die durch das Objekt verursacht wird, und einer Frequenzverschiebung aus dem Injection Pulling in der Umgebung ist.

6. Unterabtastung eines Bewegungsdetektors (100, 150, 200, 250, 300, 400) nach einem der Ansprüche 1-5, ferner **gekennzeichnet durch** einen Übermittlungsknoten zum Empfangen des ersten drahtlosen Funkfrequenzsignals und zum Übermitteln des zweiten drahtlosen Funkfrequenzsignals, wobei der zweite Oszillator (110, 210) mit dem Übermittlungsknoten elektrisch verbunden ist und das hochfrequente Oszillationssignal an den Übermittlungsknoten ausgibt, und wobei das von dem Übermittlungsknoten empfangene erste drahtlose Funkfrequenzsignal in den zweiten Oszillator (110) injiziert wird.

7. Unterabtastung eines Bewegungsdetektors (200, 250, 400), der angepasst ist, die Bewegungsinformation eines Objekts (24) während der Messung zu erfassen, wobei die Unterabtastung eines Bewegungsdetektors (200) ein erstes drahtloses Funkfrequenzsignal empfängt und ein zweites drahtloses Funkfrequenzsignal sendet, wobei das erste drahtlose Funkfrequenzsignal durch Reflektieren des zweiten drahtlosen Funkfrequenzsignals an dem Objekt (24) entsteht, wobei die Unterabtastung eines Bewegungsdetektors (200) **gekennzeichnet ist durch**:

einen ersten Oszillator (208), der ein niederfrequentes Oszillationssignal gemäß einem Steuersignal erzeugt;

einen zweiten Oszillator (110), der ein hochfrequentes Oszillationssignal ausgibt, wobei das erste drahtlose Funkfrequenzsignal in den zweiten Oszillator (110) injiziert wird, um den zweiten Oszillator (110) mittels Injection Locking zu steuern; und

einen analog-zu-digital Wandler-Unterabtaster (202), der das hochfrequente Oszillationssignal und das niederfrequente Oszillationssignal empfängt und einen Phasenunterschied zwischen dem hochfrequenten Oszillationssignal und dem niederfrequenten Oszillationssignal zu Zeitpunkten erfasst, die **durch** das niederfrequente Oszillationssignal angezeigt werden, wobei der analog-zu-digital Wandler-Unterabtaster (202) ein digitales Phasenerfassungsausgangssignal gemäß dem erfassten Phasenunterschied ausgibt, wobei das Steuersignal gemäß der Ausgabe des digitalen Phasenerfassungsausgangssignals von dem analog-zu-digital Wandler-Unterabtaster (202) erzeugt wird, und wobei die Bewegungsinformation des Objekts (24) gemäß dem digitalen Phasenerfassungsausgangssignal berechnet wird;

wobei das von dem analog-zu-digital Wandler-Unterabtaster (202) empfangene hochfrequente Oszillationssignal **durch** das erste drahtlose Funkfrequenzsignal mittels Injection Locking gesteuert wird, und das zweite drahtlose Funkfrequenzsignal von dem hochfrequenten Oszillationssignal verursacht wird.

8. Unterabtastung eines Bewegungsdetektors (300) nach Anspruch 7, ferner **gekennzeichnet durch** einen Frequenzmultiplikator (220), der zwischen dem zweiten Oszillator (210) und dem analog-zu-digital Wandler-Unterabtaster (202) in Reihe geschaltet ist, umfassend:

einen ersten Injektionsanschluss (P1), der angepasst ist, ein Injektionssignal (Vi1) zu erhalten, das einen ersten Frequenzausgang an dem zweiten Oszillator (210) aufweist;

einen Ausgangsanschluss (P3), der angepasst ist, das hochfrequente Oszillationssignal (Vo) auszugeben; und

einen zweiten Injektionsanschluss (P2), der angepasst ist, das erste drahtlose Funkfrequenzsignal (Vi2) mit einer zweiten Frequenz zu empfangen;

wobei der Frequenzmultiplikator (220) angepasst ist, das hochfrequente Oszillationssignal (Vo) in einer Frequenz mittels Injection Locking auszugeben, die im Wesentlichen gleich zu mehreren der ersten Frequenzen ist, und Ziehen des hochfrequenten Oszillationssignals (Vo) zur zweiten Frequenz mittels Injection Pulling.

9. Unterabtastung eines Bewegungsdetektors (200, 250, 400) nach einem der Ansprüche 7-8, ferner **dadurch gekennzeichnet, dass** der erste Oszillator (208) ein digital gesteuerter Oszillator ist und das Steuersignal ein digitales Steuersignal ist, und wobei die Unterabtastung eines Bewegungsdetektors (200) ferner umfasst:

einen digitalen Tiefpassfilter (204, 206), der das digitale Phasenerfassungsausgangssignal in das digitale Steuersignal wandelt, wobei der digitale Tiefpassfilter (204, 206) umfasst:

einen digitalen Tiefpassfilter mit geringer Bandbreite (204), der das digitale Phasenerfassungsausgangssignal in ein Bewegungsausgangssignal wandelt, das die Bewegungsinformation des Objekts (24) darstellt; und

einen digitalen Tiefpassfilter (206) mit großer Bandbreite, der das digitale Phasenerfassungsausgangssignal in das digitale Steuersignal wandelt.

10. Unterabtastung eines Bewegungsdetektors (100, 150, 200, 250, 300, 400) nach einem der Ansprüche 7-9, ferner **gekennzeichnet durch** einen Frequency Locked Loop (122, 212), der das niederfrequente Oszillationssignal und das hochfrequente Oszillationssignal empfängt, wobei der Frequency Locked Loop (122, 212) steuerbar ein und ausgeschaltet wird, und wobei der Frequency Locked Loop dem Unterabtastungsphasendetektor (112, 202) beim Erfassen des Phasenunterschieds zwischen dem hochfrequenten Oszillationssignal und dem niederfrequenten Oszillationssignal hilft, wenn der Frequency Locked Loop (112, 202) eingeschaltet ist.

11. Unterabtastung eines Bewegungsdetektors (100, 150, 200, 250, 300, 400) nach einem der Ansprüche 7-10, ferner **dadurch gekennzeichnet, dass** die Frequenz des niederfrequenten Oszillationssignal größer ist als oder gleich zweimal einem Frequenzunterschied zwischen der ersten drahtlosen Funkfrequenz und der Frequenz des hochfrequenten Oszillationssignals, wobei der Frequenzunterschied gleich einer Summe aus einer Doppler Frequenzverschiebung, die durch das Objekt verursacht wird, und einer Frequenzverschiebung aus dem Injection Pulling in der Umgebung ist.

12. Unterabtastung eines Bewegungsdetektors (100, 150, 200, 250, 300, 400) nach einem der Ansprüche 7-11, ferner **gekennzeichnet durch** a Übermittlungsknoten zum Empfangen des ersten drahtlosen Funkfrequenzsignals und zum Übermitteln des zweiten drahtlosen Funkfrequenzsignals, wobei der zweite Oszillator (110, 210) mit dem Übermittlungsknoten elektrisch verbunden ist und das hochfrequente Oszillationssignal an den Übermittlungsknoten ausgibt, und wobei das von dem Übermittlungsknoten empfangene erste drahtlose Funkfrequenzsignal in den zweiten Oszillator (110) injiziert wird.

## Revendications

1. Détecteur de mouvement à sous-échantillonnage (100, 150, 300) configuré pour détecter des informations de mouvement d'un objet (24) en cours de mesure, le détecteur de mouvement à sous-échantillonnage (100, 150, 300) recevant un premier signal radiofréquence sans fil et émettant un second signal radiofréquence sans fil, le premier signal radiofréquence sans fil étant généré par la réflexion du second signal radiofréquence sans fil sur l'objet, le détecteur de mouvement à sous-échantillonnage (100, 150, 300) étant **caractérisé par le fait qu'**il comprend :

  un premier oscillateur (118) générant un signal d'oscillation à basse fréquence en fonction d'un signal de commande ;
  un second oscillateur (110, 210) délivrant en sortie un signal d'oscillation à haute fréquence, le premier signal radiofréquence sans fil étant injecté dans le second oscillateur (110, 210) pour commander le second oscillateur (110, 210) par verrouillage par injection ; et
  un détecteur de phase à sous-échantillonnage (112) recevant le signal d'oscillation à haute fréquence et le signal d'oscillation à basse fréquence et détectant un déphasage entre le signal d'oscillation à haute fréquence et le signal d'oscillation à basse fréquence aux périodes temporelles indiquées par le signal d'oscillation à basse fréquence, le détecteur de phase à sous-échantillonnage (112) délivrant en sortie un signal de sortie de détection de phase en fonction du déphasage détecté, le signal de commande étant généré en fonction du signal de sortie de détection de phase délivré en sortie par le détecteur de phase à sous-échantillonnage (112), et les informations de mouvement de l'objet (24) étant calculées en fonction du signal de sortie de détection de phase ;
dans lequel le signal d'oscillation à haute fréquence reçu par le détecteur de phase à sous-échantillonnage (112) est commandé par le premier signal radiofréquence sans fil par verrouillage par injection, et le second signal radiofréquence sans fil résulte du signal d'oscillation à haute fréquence.

2. Détecteur de mouvement à sous-échantillonnage (300) selon la revendication 1, **caractérisé en outre par le fait qu'**il comprend :

  un multiplicateur de fréquence (220) couplé en série entre le second oscillateur (210) et le détecteur de phase à sous-échantillonnage (112), comprenant :

    une première borne d'injection (P1) configurée pour recevoir un signal d'injection (Vi1) ayant une première fréquence, délivré en sortie par le second oscillateur (210) ;
    une borne de sortie (P3) configurée pour délivrer en sortie le signal d'oscillation à haute fréquence (Vo) ; et
    une seconde borne d'injection (P2) configurée pour recevoir le premier signal radiofréquence sans fil (Vi2) ayant une seconde fréquence ;

  dans lequel le multiplicateur de fréquence (220) est configuré pour délivrer en sortie le signal d'oscillation à haute fréquence (Vo) à une fréquence sensiblement égale à un multiple de la première fréquence par verrouillage par injection, et tire le signal d'oscillation à haute fréquence (Vo) jusqu'à la seconde fréquence par tirage par injection.

3. Détecteur de mouvement à sous-échantillonnage (100, 150, 300) selon l'une quelconque des revendications 1 à 2, **caractérisé en outre en ce que** le premier oscillateur (118) est un oscillateur commandé en tension et le signal de commande est une tension de commande, le détecteur de mouvement à sous-échantillonnage (100, 150, 300) comprenant en outre :

  une pompe de charge (114) convertissant le signal de sortie de détection de phase reçu en provenance du détecteur de phase à sous-échantillonnage (112) en un signal de courant de sortie ; et
  un filtre à boucle (116) convertissant le signal de courant de sortie en la tension de commande.

**4.** Détecteur de mouvement à sous-échantillonnage (100, 150, 200, 250, 300, 400) selon l'une quelconque des revendications 1 à 3, **caractérisé en outre par le fait qu'**il comprend une boucle de verrouillage de fréquence (122, 212) recevant le signal d'oscillation à basse fréquence et le signal d'oscillation à haute fréquence, la boucle de verrouillage de fréquence (122, 212) pouvant être activée et désactivée de manière contrôlable, et la boucle de verrouillage de fréquence aidant le détecteur de phase à sous-échantillonnage (112, 202) à détecter le déphasage entre le signal d'oscillation à haute fréquence et le signal d'oscillation à basse fréquence lorsque la boucle de verrouillage de fréquence (112, 202) est activée.

**5.** Détecteur de mouvement à sous-échantillonnage (100, 150, 200, 250, 300, 400) selon l'une quelconque des revendications 1 à 4, **caractérisé en outre en ce que** la fréquence du signal d'oscillation à basse fréquence est supérieure ou égale à deux fois une différence de fréquence entre la première radiofréquence sans fil et la fréquence du signal d'oscillation à haute fréquence, la différence de fréquence étant égale à la somme d'un décalage de fréquence Doppler provoqué par l'objet et d'un décalage de fréquence environnemental de tirage par injection.

**6.** Détecteur de mouvement à sous-échantillonnage (100, 150, 200, 250, 300, 400) selon l'une quelconque des revendications 1 à 5, **caractérisé en outre par le fait qu'**il comprend un noeud émetteur-récepteur pour recevoir le premier signal radiofréquence sans fil et émettre le second signal radiofréquence sans fil, le second oscillateur (110, 210) étant électriquement connecté au noeud émetteur-récepteur et délivrant en sortie le signal d'oscillation à haute à fréquence au noeud émetteur-récepteur, et le premier signal radiofréquence sans fil reçu par le noeud émetteur-récepteur étant injecté dans le second oscillateur (110).

**7.** Détecteur de mouvement à sous-échantillonnage (200, 250, 400) configuré pour détecter des informations de mouvement d'un objet (24) en cours de mesure, le détecteur de mouvement à sous-échantillonnage (200) recevant un premier signal radiofréquence sans fil et émettant un second signal radiofréquence sans fil, le premier signal radiofréquence sans fil étant généré par la réflexion du second signal radiofréquence sans fil sur l'objet (24), le détecteur de mouvement à sous-échantillonnage (200) comprenant :

   un premier oscillateur (208) générant un signal d'oscillation à basse fréquence en fonction d'un signal de commande ;
   un second oscillateur (110) délivrant en sortie un signal d'oscillation à haute fréquence, le premier signal radiofréquence sans fil étant injecté dans le second oscillateur (110) pour commander le second oscillateur (110) par verrouillage par injection ; et
et
un convertisseur analogique-numérique à sous-échantillonnage (202) recevant le signal d'oscillation à haute fréquence et le signal d'oscillation à basse fréquence et détectant un déphasage entre le signal d'oscillation à haute fréquence et le signal d'oscillation à basse fréquence aux périodes temporelles indiquées par le signal d'oscillation à basse fréquence, le convertisseur analogique-numérique à sous-échantillonnage (202) délivrant en sortie un signal de sortie numérique de détection de phase en fonction du déphasage détecté, le signal de commande étant généré en fonction du signal de sortie numérique de détection de phase délivré en sortie par le convertisseur analogique-numérique à sous-échantillonnage (202), et les informations de mouvement de l'objet (24) étant calculées en fonction du signal de sortie numérique de détection de phase ;
dans lequel le signal d'oscillation à haute fréquence reçu par le convertisseur analogique-numérique à sous-échantillonnage (202) est commandé par le premier signal radiofréquence sans fil par verrouillage par injection, et le second signal radiofréquence sans fil résulte du signal d'oscillation à haute fréquence.

**8.** Détecteur de mouvement à sous-échantillonnage (300) selon la revendication 7, **caractérisé en outre par le fait qu'**il comprend : un multiplicateur de fréquence (220) couplé en série entre le second oscillateur (210) et le convertisseur analogique-numérique à sous-échantillonnage (202), comprenant :

   une première borne d'injection (P1) configurée pour recevoir le signal d'injection (Vi1) ayant une première fréquence, délivré en sortie par le second oscillateur (210) ;
   une borne de sortie (P3) configurée pour délivrer en sortie le signal d'oscillation à haute fréquence (Vo) ; et
   une seconde borne d'injection (P2) configurée pour recevoir le premier signal radiofréquence sans fil (Vi2) ayant une seconde fréquence ;

dans lequel le multiplicateur de fréquence (220) est configuré pour délivrer en sortie le signal d'oscillation à haute fréquence (Vo) à une fréquence sensiblement égale à un multiple de la première fréquence par verrouillage par injection, et tire le signal d'oscillation à haute fréquence (Vo) jusqu'à la seconde fréquence par tirage par injection.

**9.** Détecteur de mouvement à sous-échantillonnage (200, 250, 400) selon l'une quelconque des revendications 7 à 8, **caractérisé en outre en ce que** le premier oscillateur (208) est un oscillateur à commande numérique et le signal de commande est un signal de commande numérique, et le détecteur de mouvement à sous-échantillonnage (200) comprend en outre :

un filtre passe-bas numérique (204, 206) convertissant le signal de sortie numérique de détection de phase en le signal de commande numérique, le filtre passe-bas numérique (204, 206) comprenant :

un filtre passe-bas numérique à bande passante étroite (204) convertissant le signal de sortie numérique de détection de phase en un signal de sortie de mouvement représentant les informations de mouvement de l'objet (24) ; et
un filtre passe-bas numérique à large bande passante (206) convertissant le signal de sortie numérique de détection de phase en le signal de commande numérique.

**10.** Détecteur de mouvement à sous-échantillonnage (100, 150, 200, 250, 300, 400) selon l'une quelconque des revendications 7 à 9, **caractérisé en outre par le fait qu'**il comprend une boucle de verrouillage de fréquence (122, 212) recevant le signal d'oscillation à basse fréquence et le signal d'oscillation à haute fréquence, la boucle de verrouillage de fréquence (122, 212) pouvant être activée et désactivée de manière contrôlable, et la boucle de verrouillage de fréquence aidant le détecteur de phase à sous-échantillonnage (112, 202) à détecter le déphasage entre le signal d'oscillation à haute fréquence et le signal d'oscillation à basse fréquence lorsque la boucle de verrouillage de fréquence (112, 202) est activée.

**11.** Détecteur de mouvement à sous-échantillonnage (100, 150, 200, 250, 300, 400) selon l'une quelconque des revendications 7 à 10, **caractérisé en outre en ce que** la fréquence du signal d'oscillation à basse fréquence est supérieure ou égale à deux fois une différence de fréquence entre la première radiofréquence sans fil et la fréquence du signal d'oscillation à haute fréquence, la différence de fréquence étant égale à la somme d'un décalage de fréquence Doppler provoqué par l'objet et d'un décalage de fréquence environnemental de tirage par injection.

**12.** Détecteur de mouvement à sous-échantillonnage (100, 150, 200, 250, 300, 400) selon l'une quelconque des revendications 7 à 11, **caractérisé en outre par le fait qu'**il comprend un noeud émetteur-récepteur pour recevoir le premier signal radiofréquence sans fil et émettre le second signal radiofréquence sans fil, le second oscillateur (110, 210) étant électriquement connecté au noeud émetteur-récepteur et délivrant en sortie le signal d'oscillation à haute à fréquence au noeud émetteur-récepteur, et le premier signal radiofréquence sans fil reçu par le noeud émetteur-récepteur étant injecté dans le second oscillateur (110).

FIG. 1

FIG. 2

FIG. 3

EP 3 255 453 B1

FIG. 4

FIG. 5

FIG. 6

FIG. 7

EP 3 255 453 B1

FIG. 8

FIG. 9

FIG. 10

EP 3 255 453 B1

FIG. 11

EP 3 255 453 B1

FIG. 12

EP 3 255 453 B1

FIG. 13

FIG. 14

EP 3 255 453 B1

FIG. 15

FIG. 16

Digitalized $f_d$

B[n]

204 Digital LPF (low BW)

206 Digital LPF (high BW)

208 $f_s$

C[n]

A[n]

202 SSADC
out
in

216 Processing unit

212 FLL

230

225

220

P1 P3 P2

$V_o$ (f1×2→f2→f3)

Vi2 (f2→f3)

Vi1 (1f)

210

$V_o$ (f2)

Vrx(f3) f3=f2+fd

$V_o$ f3=f2+fd

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20120235689 A

- US 7737743 B